# EUROPEAN PATENT APPLICATION

(11) **EP 4 730 477 A1**
(43) Date of publication of application: **22.04.2026**
(21) Application number: 25201905.4
(22) Date of filing: 12.09.2025
(51) Int. Cl.: H01M 10/42, H01M 10/48, H01M 50/503, H01M 50/519, H01M 50/569, H05K 1/18

(54) **MANAGEMENT MODULE AND BATTERY MODULE INCLUDING THE SAME**

(30) Priority: 15.10.2024 KR 20240140465
(71) Applicant: SAMSUNG SDI CO., LTD., Yongin-si, Gyeonggi-do 17084 (KR)
(72) Inventor: AHN, Jae Pil, 16678 Suwon-si (KR)
(74) Representative: Marks & Clerk LLP

(57) **Abstract**

A management module, including a sensing module including a sensing module body, a sensing part extending from the sensing module body, the sensing part detecting operation information of battery cells, and a sensing pad portion on the sensing module body, the sensing pad portion being electrically connected to the sensing part, and a communication module including a communication module body and a communication pad portion on the communication module body, the communication module being in contact with the sensing pad portion and receiving the operation information.

## Description

### BACKGROUND

### 1. Field

The present disclosure relates to a management module and a battery module including the same.

### 2. Description of the Related Art

Secondary batteries are capable of being charged and discharged unlike primary batteries that cannot be charged. Low-capacity secondary batteries are used in small portable electronic devices such as smartphones, feature phones, notebook computers, digital cameras, and camcorders, and large-capacity secondary batteries are widely used as power sources for driving motors of hybrid vehicles, electric vehicles, etc. and batteries for power storage. Such a secondary battery includes an electrode assembly including a positive electrode and a negative electrode, a case for accommodating the electrode assembly, an electrode terminal connected to the electrode assembly, etc.

The above information disclosed in this Background section is provided for enhancement of understanding of the background of the present disclosure, and, therefore, it may contain information that does not constitute related (or prior) art.

### SUMMARY

Embodiments include a management module, including a sensing module including a sensing module body, a sensing part extending from the sensing module body, the sensing part detecting operation information of battery cells, and a sensing pad portion on the sensing module body, the sensing pad portion being electrically connected to the sensing part, and a communication module including a communication module body and a communication pad portion on the communication module body, the communication module being in contact with the sensing pad portion and receiving the operation information.

The sensing pad portion may include a concave sensing pad portion in the sensing module body, and the communication pad portion may include a protruding communication pad portion protruding from the communication module body, the protruding communication pad portion being seated in the concave sensing pad portion.

A cross-sectional area of the concave sensing pad portion may be greater than a cross-sectional area of the protruding communication pad portion.

A height of the protruding communication pad portion may be greater than a depth of the concave sensing pad portion.

The protruding communication pad portion may include a communication line in the communication module body, a communication solder electrically connected to the communication line, a communication pad electrically connected to the communication solder, and a communication plate electrically connected to the communication pad.

The concave sensing pad portion may include a sensing line in the sensing module body, and a sensing plate electrically connected to the sensing line, wherein the communication plate is in contact with and electrically connected to the sensing plate.

The sensing pad portion may include a protruding sensing pad portion protruding from the sensing module body, and the communication pad portion may include a concave communication pad portion in the communication module body and in which the protruding sensing pad portion is seated.

The management module may further include a busbar holder on which the sensing module is fixedly seated.

The busbar holder may include a busbar holder body, and a protruding busbar holder portion protruding from the busbar holder body.

The communication module may include a communication module body hole passing through the communication module body, and the protruding busbar holder portion may be inserted into the communication module body hole.

The busbar holder may include a busbar holder fixing part coupled to the protruding busbar holder portion, the busbar holder fixing part pressing the communication module toward the sensing module.

The busbar holder may include an elastic member between the communication module and the busbar holder fixing part, the elastic member preventing damage to the communication module.

The protruding busbar holder portion may include a protruding busbar holder pin protruding from the busbar holder body, and the busbar holder fixing part may include a busbar holder fixing body and a busbar holder fixing groove, the busbar holder fixing groove being concave and in the busbar holder fixing body, the protruding busbar holder pin being inserted into the busbar holder fixing groove.

The protruding busbar holder portion may include a busbar holder protrusion protruding from the busbar holder body, and the busbar holder fixing part may include a busbar holder fixing protrusion protruding from the busbar holder body, the busbar holder fixing protrusion being coupled to the protruding busbar holder protrusion.

The management module may further include an inflow prevention member between the communication module and the sensing module, the inflow prevention member surrounding the sensing pad portion and the communication pad portion.

The sensing module may include a flexible printed circuit board, and the sensing part may be connected to the plurality of battery cells.

The management module may further include a guide member on each of the sensing pad portion and the communication pad portion, wherein an attraction is generated between the guide member on the sensing pad portion and the guide member on the communication pad portion.

Embodiments include a battery module, including a housing body, a plurality of battery cells in the housing body, and a management module in the housing body, the management module collecting operation information of the plurality of battery cells, wherein the management module includes a sensing module, the sensing module including a sensing module body, a sensing part extending from the sensing module body, the sensing part detecting the operation information of the plurality of battery cells, and a sensing pad portion on the sensing module body, the sensing pad portion being electrically connected to the sensing part, and a communication module including a communication module body and a communication pad portion, the communication module being on the communication module body and in contact with the sensing pad portion, the communication module receiving the operation information through the sensing pad portion and the communication pad portion.

The management module may further include a busbar holder on which the sensing module is fixedly seated.

At least some of the above and other features of the invention are set out in the claims.

These and other aspects and features of the present disclosure will be described in or will be apparent from the following description of some embodiments of the present disclosure.

### BRIEF DESCRIPTION OF THE DRAWINGS

Features will become apparent to those of ordinary skill in the art by describing in detail example embodiments with reference to the attached drawings, in which:
FIG. 1 is a schematic exploded perspective view illustrating a configuration of a battery module according to one or more embodiments of the present disclosure;
FIG. 2 is a schematic perspective view illustrating a configuration of a battery cell according to one or more embodiments of the present disclosure;
FIG. 3 is a schematic cross-sectional view illustrating the configuration of the battery cell according to one or more embodiments of the present disclosure;
FIG. 4 is a plan view illustrating a management module disposed in a battery module according to one or more embodiments of the present disclosure;
FIG. 5 is a partial plan view illustrating the management module according to one or more embodiments of the present disclosure;
FIG. 6 is a partial perspective view illustrating the management module according to one or more embodiments of the present disclosure;
FIG. 7 is a partial exploded top perspective view illustrating the management module according to one or more embodiments of the present disclosure;
FIG. 8 is a partial exploded bottom perspective view illustrating the management module according to one or more embodiments of the present disclosure;
FIG. 9 is a cross-sectional view illustrating a state in which a sensing module is in contact with a communication module according to one or more embodiments of the present disclosure;
FIG. 10 is a cross-sectional view illustrating a state in which the sensing module is spaced apart from the communication module according to one or more embodiments of the present disclosure;
FIG. 11 is a cross-sectional view illustrating a state in which a sensing module is spaced apart from a communication module according to another embodiment of the present disclosure;
FIGS. 12 to 14 are plan views each illustrating a layout of a sensing pad portion of a sensing module and a communication pad portion of a communication module according to one or more embodiments of the present disclosure sensing module;
FIG. 15 is a cross-sectional view illustrating a state in which a sensing module is spaced apart from a communication module according to still another embodiment of the present disclosure;
FIG. 16 is a plan view illustrating an arrangement relationship between a sensing pad portion of the sensing module and a communication pad portion of the communication module according to still another embodiment of the present disclosure;
FIG. 17 is a cross-sectional view illustrating a state in which a sensing module is spaced apart from a communication module according to yet another embodiment of the present disclosure;
FIG. 18 is a cross-sectional perspective view illustrating a management module according to one or more embodiments of the present disclosure;
FIG. 19 is a cross-sectional view illustrating the management module according to one or more embodiments of the present disclosure; and
FIG. 20 is an exploded cross-sectional view illustrating the management module according to one or more embodiments of the present disclosure.

### DETAILED DESCRIPTION

Example embodiments will now be described more fully hereinafter with reference to the accompanying drawings; however, they may be embodied in different forms and should not be construed as limited to the embodiments set forth herein. Rather, these embodiments are provided so that this disclosure will be thorough and complete, and will fully convey example implementations to those skilled in the art.

In the drawing figures, the dimensions of layers and regions may be exaggerated for clarity of illustration. It will also be understood that when a layer or element is referred to as being "on" another layer or substrate, it can be directly on the other layer or substrate, or intervening layers may also be present. Further, it will be understood that when a layer is referred to as being "under" another layer, it can be directly under, and one or more intervening layers may also be present. In addition, it will also be understood that when a layer is referred to as being "between" two layers, it can be the only layer between the two layers, or one or more intervening layers may also be present. Like reference numerals refer to like elements throughout.

The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term.

The embodiments described in this specification and the configurations shown in the drawings are provided as some example embodiments of the present disclosure and do not represent all of the technical ideas, aspects, and features of the present disclosure. Accordingly, it is to be understood that there may be various equivalents and modifications that may replace or modify the embodiments described herein at the time of filing this application.

It is to be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

As used herein, the term "and/or" includes any and all combinations of one or more of the associated listed items. Further, the use of "may" when describing embodiments of the present disclosure relates to "one or more embodiments of the present disclosure". Expressions, such as "at least one of" and "any one of," when preceding a list of elements, modify the entire list of elements and do not modify the individual elements of the list. When phrases such as "at least one of A, B, and C," "at least one of A, B, or C," "at least one selected from a group of A, B, and C," or "at least one selected from among A, B, and C" are used to designate a list of elements A, B, and C, the phrase may refer to any and all suitable combinations or a subset of A, B, and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It is to be understood that, although the terms "first," "second," "third," etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It is to be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (e.g., rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It is to be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

References to two compared elements, features, etc. as being "the same" may mean that they are "substantially the same. Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

When an arbitrary element is referred to as being disposed (or located or positioned) on the "above (or below)" or "on (or under)" a component, it may mean that the arbitrary element is placed in contact with the upper (or lower) surface of the component and may also mean that another component may be interposed between the component and any arbitrary element disposed (or located or positioned) on (or under) the component.

In addition, it is to be understood that when an element is referred to as being "coupled," "linked," or "connected" to another element, the elements may be directly "coupled," "linked," or "connected" to each other, or one or more intervening elements may be present therebetween, through which the element may be "coupled," "linked," or "connected" to another element. In addition, when a part is referred to as being "electrically coupled" to another part, the part may be directly electrically connected to another part or one or more intervening parts may be present therebetween such that the part and the another part are indirectly electrically connected to each other.

Throughout the specification, when "A and/or B" is stated, it means A, B, or A and B, unless otherwise stated. That is, "and/or" includes any or all combinations of a plurality of items enumerated. When "C to D" is stated, it means C or more and D or less, unless otherwise specified.

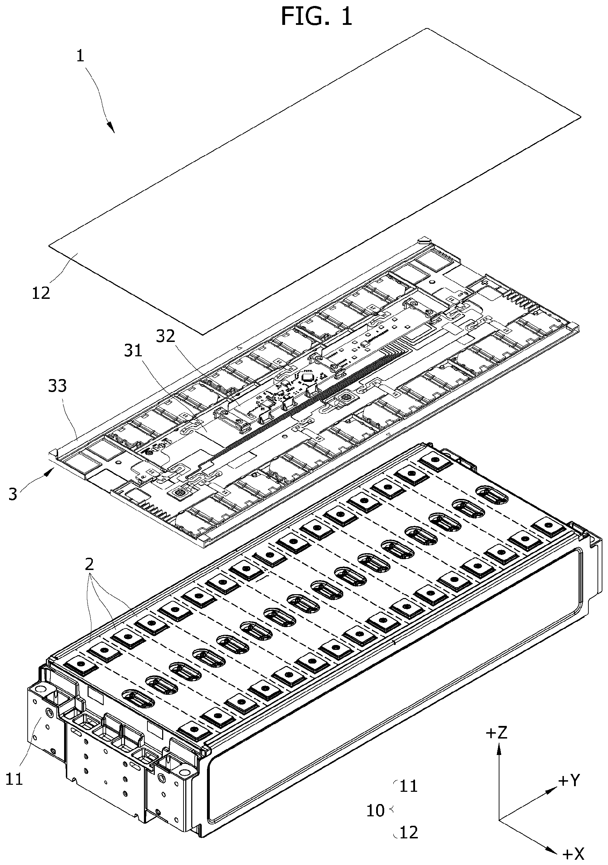

FIG. 1 is a schematic exploded perspective view illustrating a configuration of a battery module according to one or more embodiments of the present disclosure.

Referring to FIG. 1, a battery module 1 according to the present embodiment includes a housing 10, a battery cell 2, and a management module 3.

The housing 10 may include a housing body 11 and a housing cover 12.

The housing body 11 may form an overall exterior of the battery module 1 and entirely support the battery cell 2 and the management module 3 which will be described below.

The housing body 11 according to the present embodiment may be formed in a hollow box shape with an open upper side (see FIG. 1). In addition to a quadrangular shape illustrated in FIG. 1, a design of a cross-sectional shape of the housing body 11 may be variously changed according to the number of battery cells 2 and a shape thereof.

The housing cover 12 for opening or closing an inner space of the housing body 11 may be disposed at an open side of the housing body 11. The housing cover 12 according to the present embodiment may be formed to have a flat plate disposed to face an upper surface of the housing body 11. The housing cover 12 may be coupled to the housing body 11 using any one of various coupling methods such as welding and bolting methods.

The battery cell 2 may serve as a unit structure for storing and supplying power in the battery module.

The management module 3 may detect a state and/or operation information of the battery cell 2 and transmit the state and/or the operation information of the battery cell 2 by communicating with a battery management system (BMS).

The management module 3 may include a sensing module 31, a communication module 32, and a busbar holder 33. The sensing module 31 may detect a temperature, a voltage, a current, etc. of the battery cell 2, and detected information may be transmitted to the communication module 32. The busbar holder 33 may be disposed on the battery cell 2 and support the sensing module 31 and the communication module 32.

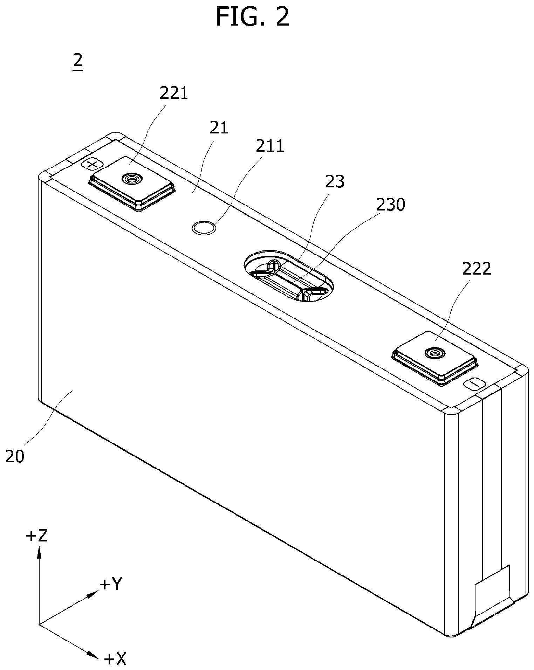

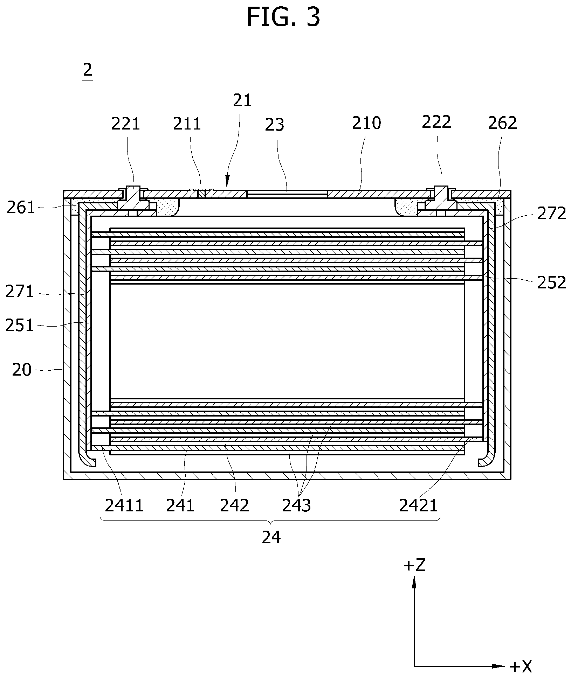

FIG. 2 is a schematic perspective view illustrating a configuration of the battery cell according to one or more embodiments of the present disclosure, and FIG. 3 is a schematic cross-sectional view illustrating the configuration of the battery cell of FIG. 2 according to one or more embodiments of the present disclosure.

Referring to FIGS. 2 and 3, the battery cell 2 may include one or more electrode assemblies 24 in which a positive electrode 241, a negative electrode 242, and a separator 243, which is an insulator and is disposed between the positive electrode 241 and the negative electrode 242, are wound, a case 20 in which the electrode assembly 24 is installed, and a cap assembly 21 coupled to an opening of the case 20.

Hereinafter, a prismatic lithium-ion secondary battery will be described as an example of the battery cell 2. However, the battery cell 2 may be a lithium polymer battery or a cylindrical battery.

The electrode assembly 24 may have a roll shape in which the positive electrode 241, the negative electrode 242, and the separator 243, which is the insulator and is interposed between the positive electrode 241 and the negative electrode 242, are wound. However, the electrode assembly 24 may also be formed in a stacked structure in which the positive electrode 241 and the negative electrode 242 formed of a plurality of sheets are stacked with the separator 243 interposed therebetween.

The positive electrode 241 and the negative electrode 242 may include coated portions which are regions in which thin metal foils are coated with active materials and uncoated portions 2411 and 2421 which are regions which are not coated with active materials.

The case 20 may form an overall exterior of the battery cell 2 and provide a space in which the electrode assembly 24 is accommodated. The case 20 according to the present embodiment may have a hollow rectangular hexahedral shape with an open side. The case 20 may be formed of a conductive metal such as aluminum, an aluminum alloy, or steel coated with nickel.

The cap assembly 21 may be coupled to the case 20 and seal the case 20.

The cap assembly 21 according to the present embodiment may include a cap plate 210 covering an opening of the case 20. The cap plate 210 may be formed of a conductive material. A positive terminal 221 and a negative terminal 222 electrically connected to the positive electrode 241 and the negative electrode 242 may be installed to pass through the cap plate 210 and protrude outward.

Upper outer circumferential surfaces of the positive terminal 221 and the negative terminal 222 protruding outward from the cap plate 210 may be screw-processed and fixed to the cap plate 210 using nuts. However, the positive terminal 221 and the negative terminal 222 may be formed to have rivet structures and rivet-coupled or welded to the cap plate 210.

An electrolyte injection hole 211, in which a sealing stopper may be installed, may be formed in the cap plate 210.

A notch 230 and a vent part 23 for performing an opening operation when an internal pressure of the case 20 increases may be formed in the cap plate 210.

The positive terminal 221 and the negative terminal 222 may be electrically connected to a current collector 251 and a second current collector 252 welded to the positive uncoated portion 2411 or the negative uncoated portion 2421.

For example, the positive terminal 221 and the negative terminal 222 may be welded to the first current collector 251 and the second current collector 252, respectively. However, the positive terminal 221 and the negative terminal 222 may be formed to be integrally coupled to the first current collector 251 and the second current collector 252.

An insulating member may be installed between the electrode assembly 24 and the cap plate 210. In this case, the insulating member may include a first insulating member 261 and a second insulating member 262, and each of the first insulating member 261 and the second insulating member 262 may be installed between the electrode assembly 24 and the cap plate 210.

According to the present embodiment, one end of a separation member installed to face one side surface of the electrode assembly 24 may be installed between the insulating member and the positive terminal 221 and negative terminal 222. In this case, the separation member may include a first separation member 271 and a second separation member 272.

One end of the first separation member 271 and the second separation member 272 installed to face one side surface of the electrode assembly 24 may be installed between the first insulating member 261 and second insulating member 262 and the positive terminal 221 and negative terminal 222.

The positive terminal 221 and the negative terminal 222 welded to the first current collector 251 and the second current collector 252 may be coupled to one end of the first insulating member 261, the second insulating member 262, the first separation member 271, and the second separation member 272.

The battery cell 2 may be disposed in the housing body 11. In the battery cell 2 according to the present embodiment, the cap plate 210 may be disposed to face the housing cover 12 in the housing body 11.

The battery cell 2 may be provided as a plurality of battery cells 2. The plurality of battery cells 2 may be disposed in parallel in the housing body 11. As an example, the plurality of battery cells 2 may be disposed in a Y-axis direction based on FIG. 1. The number of battery cells 2 may vary from that illustrated in FIG. 1, and a design and the number thereof may be variously changed according to a size and the like of the battery module 1.

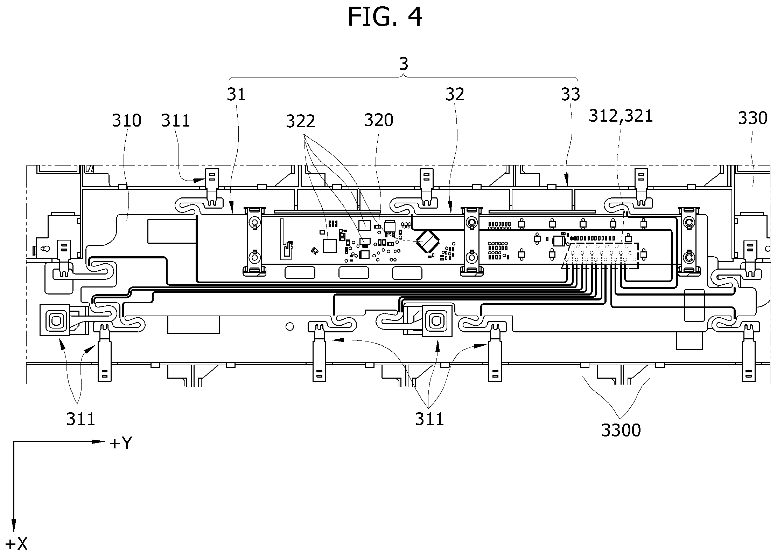

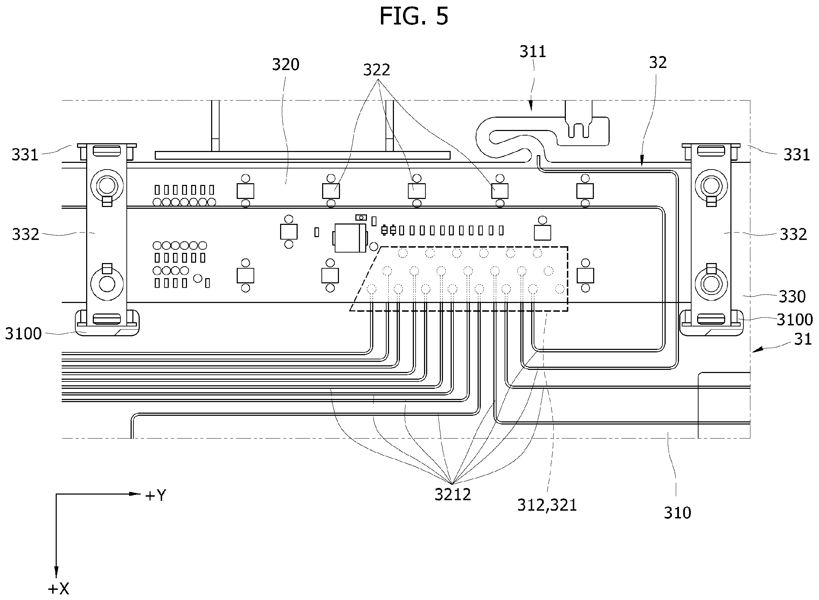

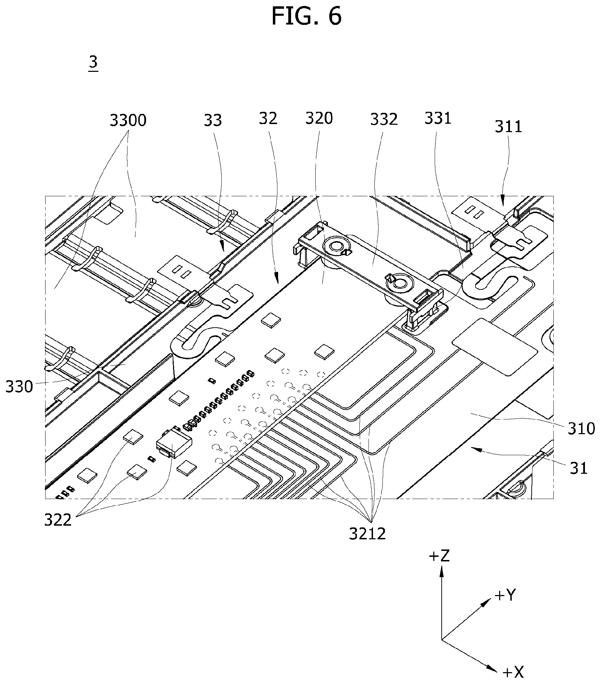

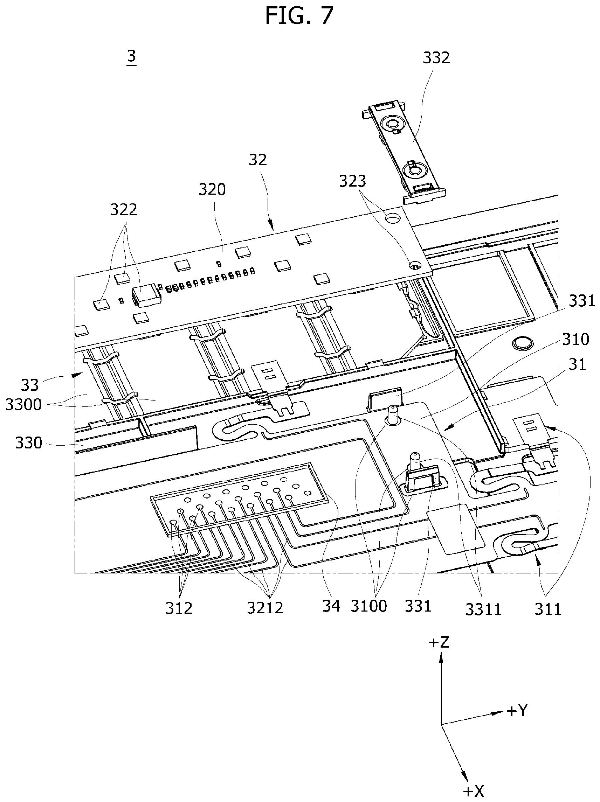

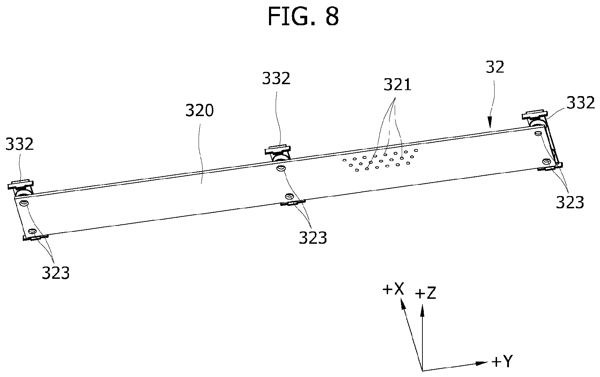

FIG. 4 is a plan view illustrating a management module disposed in a battery module according to one or more embodiments of the present disclosure, and FIG. 5 is a partial plan view illustrating the management module according to one or more embodiments of the present disclosure. FIG. 6 is a partial perspective view illustrating the management module according to one or more embodiments of the present disclosure, and FIG. 7 is a partial exploded top perspective view illustrating the management module according to one or more embodiments of the present disclosure. FIG. 8 is a partial exploded bottom perspective view illustrating the management module according to one or more embodiments of the present disclosure.

A battery cell 2 and a management module 3 illustrated in FIGS. 4 to 8 are the same as the battery cell 2 and the management module 3 illustrated in FIGS. 1 to 3. Accordingly, descriptions of the same components may be omitted.

Hereinafter, a configuration of the management module 3 will be briefly described.

The management module 3 may include a sensing module 31 and a communication module 32.

The sensing module 31 may be in contact with the battery cell 2 or electrically connected to a positive terminal 221 and/or a negative terminal 222 of the battery cell 2 and may detect operation information of the battery cell 2. The sensing module 31 may detect operation information of a voltage, a current, and a temperature of the battery cell 2. The sensing module 31 may detect operation information of a plurality of battery cells 2.

The operation information of the battery cell 2 detected by the sensing module 31 may be transmitted to a communication module 32 electrically connected to the sensing module 31. According to one or more embodiments, the sensing module 31 and the communication module 32 are connected through a wire so that the operation information of the battery cell 2 may be transmitted to the communication module 32.

The communication module 32 may transmit the operation information of the battery cell 2 received from the sensing module 31 to a BMS. According to one or more embodiments, the communication module 32 may wirelessly transmit the operation information of the battery cell 2 to the BMS.

The management module 3 may further include a busbar holder 33.

The busbar holder 33 may be disposed on the battery cell 2 and support the sensing module 31 and the communication module 32. According to one or more embodiments, the busbar holder 33 may be disposed on the battery cell 2. The busbar holder 33 may support a busbar (for example, a busbar 3300 of FIG. 4) electrically connected to the positive terminal 221 and/or the negative terminal 222 of the battery cell 2. As the busbar 3300 is supported by the busbar holder 33, the movement of the busbar may be restricted, and even when the battery module 1 is externally impacted, the busbar may be prevented from being separated from the positive terminal 221 and/or the negative terminal 222.

Hereinafter, a detailed configuration of the management module 3 will be described.

The sensing module 31 may include a sensing module body 310, a sensing part 311, and a sensing pad portion 312.

The sensing module body 310 may be provided as a flexible printed circuit board (FPCB). As described above, as the sensing module body 310 is provided as the FPCB, a shape of the sensing module body 310 may be relatively freely changed.

The sensing module body 310 may be disposed on the busbar holder 33. According to one or more embodiments, the sensing module body 310 may be disposed on the busbar holder 33. The sensing module body 310 may be disposed on the busbar holder 33 and connected to the battery cell 2.

The sensing module 31 may include a sensing module body hole 3100 (best shown in FIG. 7) provided as a hole passing through the sensing module body 310. The sensing module body hole 3100 may be provided as a plurality of sensing module body holes 3100. The busbar holder 33 may be inserted into the sensing module body hole 3100. According to one or more embodiments, a protruding busbar holder portion 331 and/or a protruding busbar holder pin 3311 of the busbar holder 33 may be inserted into the sensing module body hole 3100. Accordingly, the sensing module body 310 may be fixed to the busbar holder 33.

The sensing part 311 may extend from the sensing module body 310. The sensing part 311 may be provided as an FPCB. The sensing part 311 may extend from the sensing module body 310 and be in contact with or may be connected to the battery cell 2 and/or the busbar 3300 of the busbar holder 33. The sensing part 311 may be provided as a plurality of sensing parts 311. Accordingly, operation information or state information of the battery cell 2 and/or the busbar 3300 may be detected by the sensing part 311.

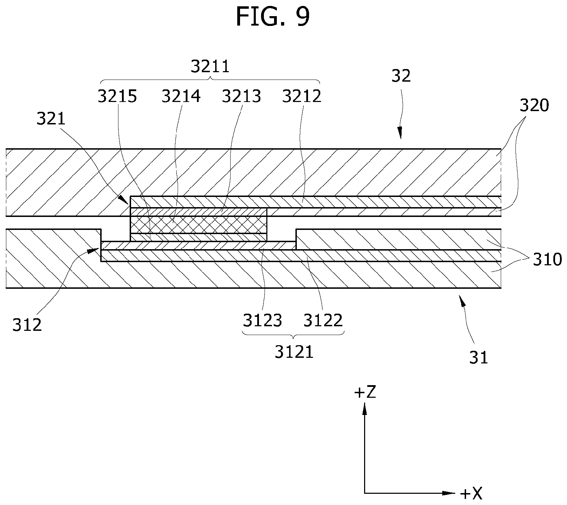

As the sensing part 311 is in contact with or connected to the battery cell 2 and/or the busbar 3300, the sensing module 31 may detect the operation information of the battery cell 2. According to one or more embodiments, the sensing part 311 may detect a temperature, a current, a voltage, etc. of the battery cell 2. The operation information of the battery cell 2 detected by the sensing part 311 may be transmitted to the sensing pad portion 312 through a sensing line 3122 (see FIG. 9) of the sensing module body 310. The sensing line 3122 may be disposed in the sensing module body 310.

The sensing pad portion 312 may be connected to the sensing line 3122. A plurality of sensing lines 3122 connected to the plurality of sensing parts 311 may be connected to the sensing pad portion 312. The sensing pad portion 312 may be disposed on the sensing module body 310 and be in contact with the communication module 32. The sensing pad portion 312 may be disposed on the sensing module body 310.

According to one or more embodiments, the sensing pad portion 312 may be in contact with a communication pad portion 321 of the communication module 32. As the sensing pad portion 312 and the communication pad portion 321 are in contact with and electrically connected to each other, the operation information and/or state information of the battery cell 2 and/or the busbar 3300 detected by the sensing part 311 may be transmitted to the communication module 32 through the sensing pad portion 312 and the communication pad portion 321.

As the sensing pad portion 312 and the communication pad portion 321 (see FIG. 5) are provided to be in contact with each other instead of being provided as connectors, a shape of the sensing module body 310 for movement of a connector may not be needed. As described above, as the shape for the movement of the connector is not needed, the sensing module body 310 does not need to be cut, and as the sensing module body 310 is not cut, scraps may not be generated, thereby minimizing waste of materials. In addition, as the shape of the sensing module body 310 for connection of the connectors is not needed, the sensing module body 310 does not need to be cut, the sensing lines 3122 do not need to be concentrated, and a bottleneck phenomenon cannot occur.

The communication module 32 may include a communication module body 320, the communication pad portion 321, a communication module element 322, and a communication module body hole 323 (see FIG. 7).

The communication module body 320 may be provided as a printed circuit board (PCB), but may be provided as an FPCB. The communication module body 320 may be disposed on the sensing module 31. According to one or more embodiments, the communication module body 320 may be disposed on the sensing module body 310. As described above, as the communication module body 320 is disposed on the sensing module body 310, the busbar holder 33, the sensing module body 310, and the communication module body 320 may be sequentially stacked.

The communication pad portion 321, the communication module element 322, and the communication module body hole 323 may be disposed on the communication module body 320.

The communication pad portion 321 may be disposed on the communication module body 320 and be in contact with the sensing pad portion 312 of the sensing module body 310. According to one or more embodiments, the communication pad portion 321 may be on a lower portion of the communication module body 320.

As the communication pad portion 321 is in contact with and electrically connected to the sensing pad portion 312, the communication module 32 may receive a signal from the sensing module 31. The signal transmitted to the communication module 32 from the sensing module 31 may include operation information and state information of the battery cell 2 and/or the busbar holder 33.

The communication module element 322 may be disposed on the communication module body 320. The communication module element 322 may be electrically connected to the communication pad portion 321, receive the signal transmitted from the sensing pad portion 312, and transmit or receive a signal to or from a component outside the management module 3.

According to one or more embodiments, the management module 3 may wirelessly communicate with the BMS. As the management module 3 wirelessly communicates with the BMS, the operation information and/or the state information of the battery cell 2 and/or the busbar 3300 may be transmitted to the BMS.

The communication module 32 may include the communication module body hole 323 provided as a hole passing through the communication module body 320. The communication module body hole 323 may be provided as a plurality of communication module body holes 323. The busbar holder 33 may be inserted into the communication module body hole 323. According to one or more embodiments, the protruding busbar holder pin 3311 of the busbar holder 33 may be inserted into the communication module body hole 323. As the busbar holder 33 is inserted into the communication module body hole 323, the communication module body 320 may be fixed to the busbar holder 33.

The busbar holder 33 may include a busbar holder body 330, the busbar 3300, the protruding busbar holder portion 331, and a busbar holder fixing part 332.

The busbar holder 33 may be disposed between the battery cell 2 and the sensing module 31. The busbar holder body 330 may be seated on the battery cell 2, and the busbar 3300, the protruding busbar holder portion 331, and the busbar holder fixing part 332 may be disposed on the busbar holder body 330.

The busbar 3300 may connect electrodes of the battery cells 2. According to one or more embodiments, the busbar 3300 may be connected to a positive terminal 221 and/or a negative terminal 222 of the battery cells 2. Accordingly, the plurality of battery cells 2 may be connected in series and/or in parallel. As the plurality of battery cells 2 are connected in series and/or in parallel, a voltage may increase, or a value limit of a flowable current may increase. Accordingly, the capacity of the battery module 1 can increase.

The protruding busbar holder portion 331 may be disposed to protrude from the busbar holder body 330. According to one or more embodiments, the protruding busbar holder portion 331 may protrude upward (for example, in a +Z-axis direction) from the busbar holder body 330. The protruding busbar holder portion 331 may protrude upward from the busbar holder body 330 and may be coupled to the busbar holder fixing part 332.

The protruding busbar holder pin 3311 may be disposed to protrude from the busbar holder body 330. According to one or more embodiments, the protruding busbar holder pin 3311 may protrude upward (for example, in the +Z-axis direction) from the busbar holder body 330. The protruding busbar holder pin 3311 may be disposed to pass through the sensing module body hole 3100 of the sensing module 31 and/or the communication module body hole 323 of the communication module 32. The protruding busbar holder pin 3311 passing through the sensing module body hole 3100 and/or the communication module body hole 323 may be fixed to the busbar holder fixing part 332. According to one or more embodiments, the protruding busbar holder pin 3311 may be inserted into a busbar holder fixing groove 3321 of the busbar holder fixing part 332. As the protruding busbar holder pin 3311 is inserted into the busbar holder fixing groove 3321, the sensing module 31 and/or the communication module 32 can be prevented from being separated from the busbar holder 33.

The busbar holder fixing part 332 may be disposed on (for example, in a +Z-axis direction of) the sensing module 31 and/or the communication module 32. According to one or more embodiments, the busbar holder fixing part 332 may be disposed on the communication module 32 and coupled to the protruding busbar holder portion 331.

An inflow prevention member 34 (see FIG. 7) may be disposed on the sensing module body 310. The inflow prevention member 34 may be disposed between the sensing module 31 and the communication module 32. According to one or more embodiments, the inflow prevention member 34 may be disposed on the sensing module body 310 to surround the sensing pad portion 312 and the communication pad portion 321. As the inflow prevention member 34 is disposed to surround the sensing pad portion 312 and the communication pad portion 321, foreign matter such as water can be prevented from being introduced to the sensing pad portion 312 and the communication pad portion 321.

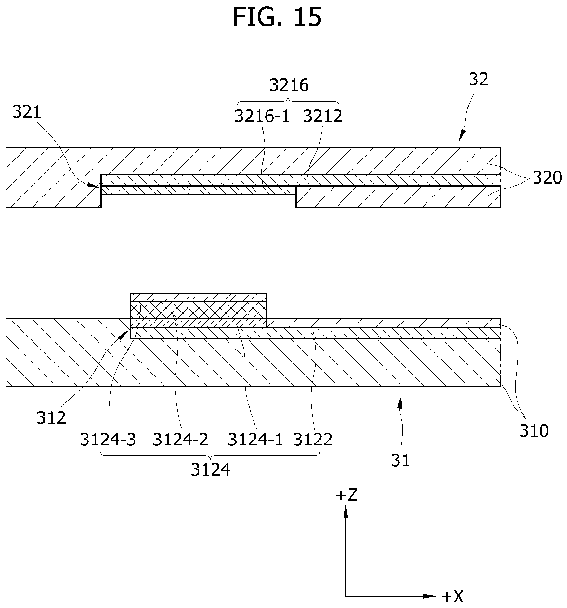

In FIG. 7, it is illustrated that one inflow prevention member 34 is disposed to surround the sensing pad portion 312 and the communication pad portion 321, but an example of the inflow prevention member 34 is not limited thereto. The inflow prevention member 34 may be disposed on each terminal (for example, a concave sensing pad portion 3121 or a protruding communication pad portion 3211 of FIG. 9, or a protruding sensing pad portion 3124 or a concave communication pad portion 3216 of FIG. 15) in contact with the sensing pad portion 312 and the communication pad portion 321 to surround an individual terminal.

As described above, the sensing module 31 and/or the communication module 32 may be disposed on the busbar holder 33 and fixed to the busbar holder 33 by the protruding busbar holder portion 331 and/or the busbar holder fixing part 332.

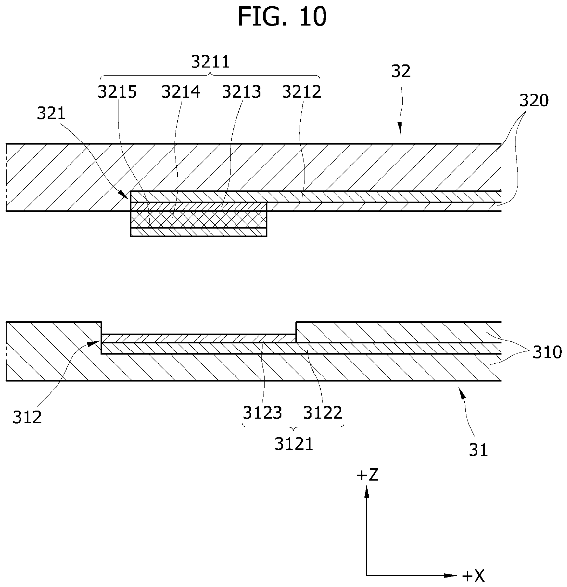

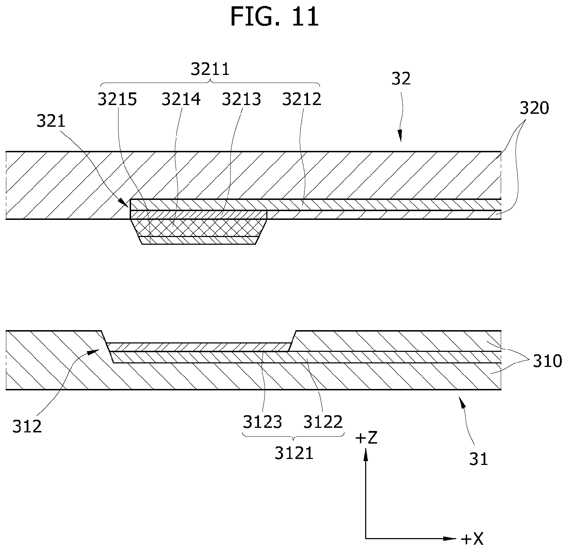

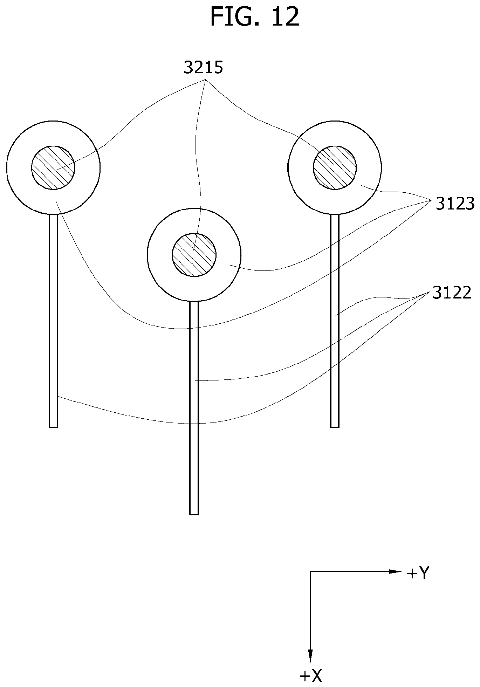

FIG. 9 is a cross-sectional view illustrating a state in which a sensing module is in contact with a communication module according to one or more embodiments of the present disclosure, and FIG. 10 is a cross-sectional view illustrating a state in which the sensing module is spaced apart from the communication module according to one or more embodiments of the present disclosure. FIG. 11 is a cross-sectional view illustrating a state in which a sensing module is spaced apart from a communication module according to another embodiment of the present disclosure, and FIGS. 12 to 14 are plan views each illustrating a layout of a sensing pad portion of a sensing module and a communication pad portion of a communication module according to one or more embodiments of the present disclosure sensing module.

A sensing module 31, a sensing module body 310, a sensing pad portion 312, a sensing line 3122, a communication module 32, a communication module body 320, and a communication pad portion 321 illustrated in FIGS. 9 to 14 are the same as the sensing module 31, the sensing module body 310, the sensing pad portion 312, the sensing line 3122, the communication module 32, the communication module body 320, and the communication pad portion 321 illustrated in FIGS. 1 to 8. Accordingly, description of the same components may be omitted.

Referring to FIGS. 9 and 10, the sensing pad portion 312 of the sensing module 31 and the communication pad portion 321 of the communication module 32 can be seen.

As the sensing pad portion 312 and the communication pad portion 321 are not implemented as connectors, and the sensing module 31 and the communication module 32 are disposed to overlap each other, the sensing pad portion 312 and the communication pad portion 321 may be in contact with and electrically connected to each other.

As described above, as the sensing pad portion 312 and the communication pad portion 321 overlap and are electrically connected, an additional connector structure is not needed. As the connector structure is not needed, a volume of a space needed for connecting the sensing module 31 and the communication module 32 may decrease, and a degree of integration of a circuit may decrease, thereby preventing a bottleneck phenomenon and lowering difficulty in a circuit design.

In addition, as the sensing module 31 provided as an FPCB does not need a connector structure, the sensing module 31 does not need to be cut for connection with a connector. Accordingly, a process of manufacturing the sensing module 31 can be simplified, a time for manufacturing the sensing module 31 can decrease, and a cost for the sensing module 31 can decrease.

When the connector structure is implemented on the sensing module 31 and/or the communication module 32, a worker should pay close attention during detaching or attaching the connector, and a possibility of damage to the sensing module 31 and/or the communication module 32 is great. As the connector structure is not needed, the communication module 32 may be easily attached to or detached from the sensing module 31. In addition, a process of separating the communication module 32 from the sensing module 31 can be simplified greatly, and a difficulty in the separating process can decrease.

Referring to FIGS. 9 and 10, the sensing line 3122 may be disposed in the sensing module body 310 of the sensing module 31. According to one or more embodiments, the sensing line 3122 may be disposed in the sensing module body 310. The sensing line 3122 may be connected to a sensing part 311 and transmit information detected by the sensing part 311 to the sensing pad portion 312.

The sensing line 3122 may be connected to the sensing pad portion 312.

The sensing pad portion 312 may include a concave sensing pad portion 3121 concavely formed in the sensing module body 310. The concave sensing pad portion 3121 may be provided as a groove concavely formed downward (for example, in a -Z-axis direction) from an upper side (for example, in a +Z-axis direction) of the sensing module body 310.

A sensing plate 3123 may be disposed on the concave sensing pad portion 3121. According to one or more embodiments, the sensing plate 3123 may be disposed on (for example, in a +Z-axis direction of) the sensing line 3122 and electrically connected to the sensing line 3122 and transmit an electrical signal to the sensing line 3122. The sensing plate 3123 may be in contact with the communication module 32. According to one or more embodiments, the sensing plate 3123 may be in contact with and electrically connected to the communication pad portion 321 of the communication module 32. The sensing plate 3123 may include a highly conductive material such as gold, silver, and copper. As the sensing line 3122 and the communication module 32 are connected through the sensing plate 3123 without being directly connected thereto, the sensing plate 3123 can protect the sensing line 3122.

The communication pad portion 321 may be disposed in the concave sensing pad portion 3121. According to one or more embodiments, the communication pad portion 321 may be inserted into the concave sensing pad portion 3121.

A communication line 3212 may be disposed in the communication module body 320. According to one or more embodiments, the communication line 3212 may be disposed in the communication module body 320. The communication line 3212 may be connected to the communication pad portion 321 and may transmit an electrical signal to the communication pad portion 321. According to one or more embodiments, a signal transmitted to the communication pad portion 321 through the sensing pad portion 312 may be transmitted to a communication module element 322 (see FIG. 7) of the communication module 32 through the communication line 3212.

The communication pad portion 321 may include a protruding communication pad portion 3211 protruding from the communication module body 320. The protruding communication pad portion 3211 may protrude downward (for example, in a -Z-axis direction) from an upper side (for example, in a +Z-axis direction) of the communication module body 320.

The protruding communication pad portion 3211 may be inserted into and come into contact with the concave sensing pad portion 3121. As the protruding communication pad portion 3211 is inserted into and comes into contact with the concave sensing pad portion 3121, the protruding communication pad portion 3211 and the concave sensing pad portion 3121 may be electrically connected to each other. Accordingly, the sensing module 31 and the communication module 32 may be electrically connected.

The protruding communication pad portion 3211 may be connected to the communication line 3212, and a communication solder 3213 may be disposed under (for example, in a -Z-axis direction of) the communication line 3212.

The communication solder 3213 may be a solder and be disposed in a manufacturing process. The communication solder 3213 may electrically connect the communication line 3212 and the communication pad 3214 and fix the communication pad 3214.

The communication pad 3214 may be disposed under (for example, in a - Z-axis direction of) the communication solder 3213 and electrically connected to the communication solder 3213. The communication pad 3214 may be electrically connected to the sensing line 3122. The communication pad 3214 may be formed of a highly conductive conductor.

A communication plate 3215 may be disposed under (for example, in a - Z-axis direction of) the communication pad 3214 and electrically connected to the communication pad 3214. As the communication pad 3214 is connected to the sensing module 31 through the communication plate 3215 without being directly connected thereto, the communication plate 3215 may protect the communication pad 3214. The communication plate 3215 may be formed of a highly conductive conductor such as gold, silver, and copper.

Referring to FIG. 11, it can be seen that a shape of a concave sensing pad portion 3121 and a shape of the protruding communication pad portion 3211 are different from each other.

A cross-sectional area of a concave sensing pad portion 3121 and a protruding communication pad portion 3211 may increase in one direction. According to one or more embodiments, the cross-sectional area of the concave sensing pad portion 3121 perpendicular to a Z-axis direction may increase in a +Z-axis direction.

An inclination intersecting the Z-axis direction may be provided on a portion of the sensing module body 310 and a portion of a cross section of a sensing plate 3123 of the concave sensing pad portion 3121. According to one or more embodiments, a cross-sectional shape of the portion of the sensing module body 310 and the sensing plate 3123 of the concave sensing pad portion 3121 may be provided as a substantially trapezoidal shape.

An inclination intersecting the Z-axis direction may be formed on a portion of the communication module body 320 and a portion of a cross section of a communication pad 3214 and a communication plate 3215 of the protruding communication pad portion 3211. According to one or more embodiments, a cross-sectional shape of the portion of the communication module body 320, the communication pad 3214, and the communication plate 3215 of the protruding communication pad portion 3211 may be provided as a substantially trapezoidal shape.

As described above, as the cross-sectional shape is provided as the substantially trapezoidal shape, when the communication module 32 comes into contact with the sensing module 31, contact between the sensing pad portion 312 and the communication pad portion 321 may be guided.

Referring to FIGS. 9 to 11, an area of the concave sensing pad portion 3121 may be formed to be greater than an area of the protruding communication pad portion 3211. According to one or more embodiments, the area of the concave sensing pad portion 3121 cut in a direction perpendicular to the Z-axis direction may be formed to be greater than the area of the protruding communication pad portion 3211.

As described above, as the area of the concave sensing pad portion 3121 is formed to be greater than the area of the protruding communication pad portion 3211, even when the communication module 32 is not disposed at an accurate location desired by a designer, the sensing module 31 and the communication module 32 may be electrically connected. An example thereof will be described with reference FIGS. 12 to 14.

Referring to FIG. 12, it can be seen that the sensing module 31 and/or the communication module 32 are accurately disposed at designed locations so that a protruding communication pad portion 3211 is disposed at a center of a concave sensing pad portion 3121 of the sensing module 31. Accordingly, it can be seen that a communication plate 3215 of the protruding communication pad portion 3211 is disposed at a center of a sensing plate 3123 of the concave sensing pad portion 3121.

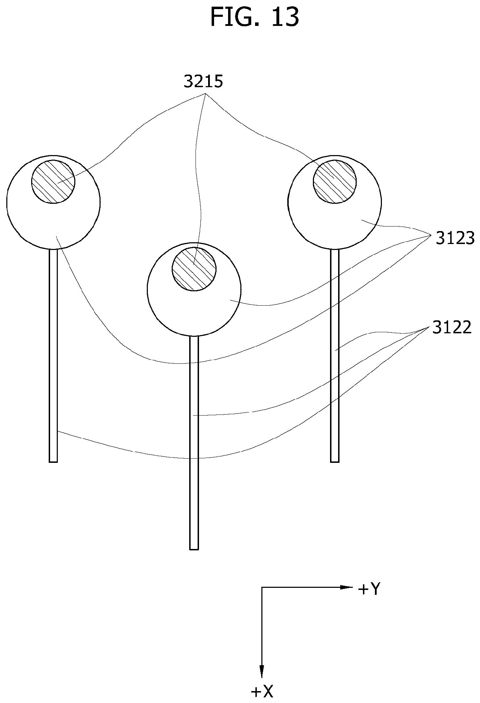

Referring to FIG. 13, it can be seen that the sensing module 31 and/or the communication module 32 is disposed to be biased in one direction (for example, a -X-axis direction) without being accurately disposed at a designed location so that a protruding communication pad portion 3211 is disposed in an end portion of one side (for example, in a -X-axis direction) of a concave sensing pad portion 3121. Accordingly, it can be seen that a communication plate 3215 of the protruding communication pad portion 3211 is disposed in an end portion of one side (for example, in the -X-axis direction) of a sensing plate 3123 of the concave sensing pad portion 3121.

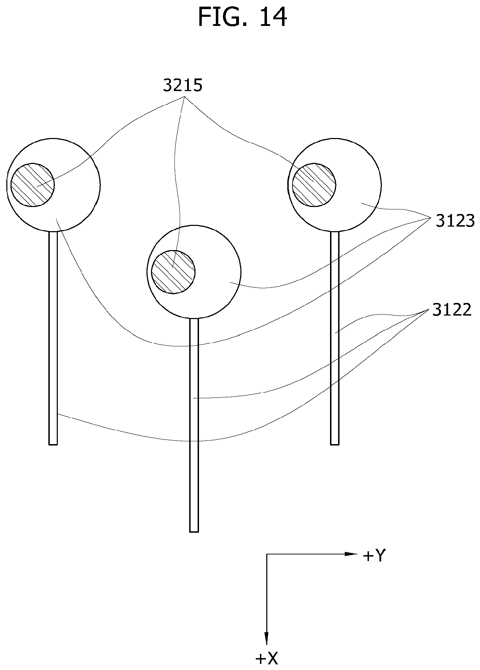

Referring to FIG. 14, it can be seen that the sensing module 31 and/or the communication module 32 is disposed to be biased in one direction (for example, in a -Y-axis direction) without being accurately disposed at a designed location so that a protruding communication pad portion 3211 is disposed in an end portion of one side (for example, in a -Y-axis direction) of a concave sensing pad portion 3121. Accordingly, it can be seen that a communication plate 3215 of the protruding communication pad portion 3211 is disposed in an end portion of one side (for example, in a -Y-axis direction) of a sensing plate 3123 of the concave sensing pad portion 3121.

As in FIGS. 12 to 14, as an area of the concave sensing pad portion 3121 is formed to be greater than an area of the protruding communication pad portion 3211, even when the sensing module 31 and/or the communication module 32 is not accurately disposed at a designed location, the sensing module 31 and the communication module 32 may be electrically connected. Accordingly, preciseness needed for assembling a management module 3 can be lowered, and a manufacturing (assembling) time can be reduced.

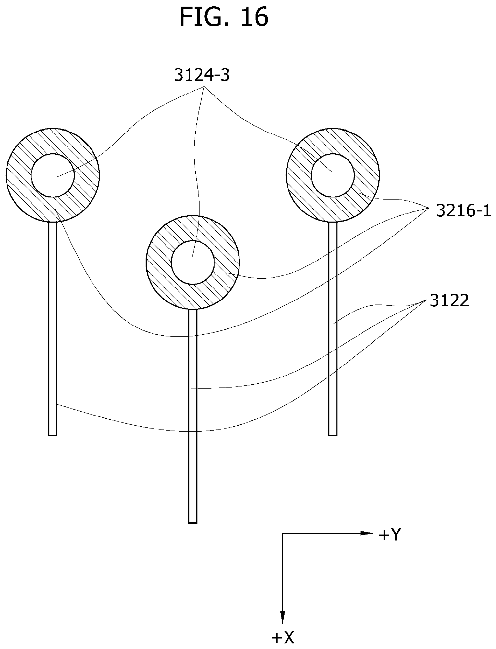

FIG. 15 is a cross-sectional view illustrating a state in which a sensing module is spaced apart from a communication module according to still another embodiment of the present disclosure, and FIG. 16 is a plan view illustrating an arrangement relationship between a sensing pad portion of the sensing module and a communication pad portion of the communication module according to still another embodiment of the present disclosure.

The embodiment illustrated in FIGS. 15 and 16 is similar to the embodiment illustrated in FIGS. 10 and 11. The embodiment, in which a sensing pad portion 312 protrudes from a sensing module body 310 and a communication pad portion 321 is concavely formed in a communication module body 320, is illustrated in FIGS. 15 and 16.

The sensing pad portion 312 may include a protruding sensing pad portion 3124, and the communication pad portion 321 may include a concave communication pad portion 3216.

The protruding sensing pad portion 3124 may be inserted into and come into contact with the concave communication pad portion 3216. As the protruding sensing pad portion 3124 and the concave communication pad portion 3216 come into contact with each other, a sensing module 31 and a communication module 32 may be electrically connected.

The protruding sensing pad portion 3124 may include a protruding sensing solder 3124-1, a protruding sensing pad 3124-2, and a protruding sensing plate 3124-3.

The protruding sensing pad portion 3124 may be disposed in the communication pad portion 321. According to one or more embodiments, the protruding sensing pad portion 3124 may be inserted into the communication pad portion 321.

A sensing line 3122 may be disposed in the sensing module body 310. According to one or more embodiments, the sensing line 3122 may be disposed in the sensing module body 310. The sensing line 3122 may be connected to the sensing pad portion 312 and transmit an electrical signal to the sensing pad portion 312.

The sensing pad portion 312 may include the protruding sensing pad portion 3124 formed to protrude from the sensing module body 310. The protruding sensing pad portion 3124 may protrude upward (for example, in a +Z-axis direction) from a lower side (for example, in a -Z-axis direction) of the sensing module body 310.

The protruding sensing pad portion 3124 may be inserted into and come into contact with the concave communication pad portion 3216. As the protruding sensing pad portion 3124 is inserted into and comes into contact with the concave communication pad portion 3216, the protruding sensing pad portion 3124 and the concave communication pad portion 3216 may be electrically connected. Accordingly, the sensing module 31 and the communication module 32 may be electrically connected.

The protruding sensing pad portion 3124 may be connected to the sensing line 3122, and the protruding sensing solder 3124-1 may be disposed on (for example, in a +Z-axis direction of) the sensing line 3122.

The protruding sensing solder 3124-1 may be a solder and be disposed in a manufacturing process. The protruding sensing solder 3124-1 may electrically connect the sensing line 3122 and the protruding sensing pad 3124-2 and fix the protruding sensing pad 3124-2.

The protruding sensing pad 3124-2 may be disposed on (for example, in a +Z-axis direction of) the protruding sensing solder 3124-1 and electrically connected to the protruding sensing solder 3124-1. The protruding sensing pad 3124-2 may be electrically connected to a communication line 3212. The protruding sensing pad 3124-2 may be formed of a highly conductive conductor.

The protruding sensing plate 3124-3 may be disposed on (for example, in a +Z-axis direction of) the protruding sensing pad 3124-2 and electrically connected to the protruding sensing pad 3124-2. As the protruding sensing pad 3124-2 is connected to the communication module 32 through the protruding sensing plate 3124-3 without being directly connected thereto, the protruding sensing plate 3124-3 may protect the protruding sensing pad 3124-2. The protruding sensing plate 3124-3 may be formed of a highly conductive conductor such as gold, silver, and copper.

The concave communication pad portion 3216 may include a concave communication plate 3216-1.

The concave communication plate 3216-1 may be disposed in the concave communication pad portion 3216. According to one or more embodiments, the concave communication plate 3216-1 may be disposed under (for example, in a -Z-axis direction of) the communication line 3212 and electrically connected to the communication line 3212 and may transmit an electrical signal to the communication line 3212. The concave communication plate 3216-1 may be in contact with the sensing module 31. According to one or more embodiments, the concave communication plate 3216-1 may be in contact with and electrically connected to the sensing pad portion 312 of the sensing module 31. The concave communication plate 3216-1 may include a highly conductive material such as gold, silver, and copper. As the communication line 3212 is connected to the sensing module 31 through the concave communication plate 3216-1 without being directly connected thereto, the concave communication plate 3216-1 may protect the communication line 3212.

An area of the concave communication pad portion 3216 may be formed to be greater than an area of the protruding sensing pad portion 3124. According to one or more embodiments, the area of the concave communication pad portion 3216 cut in a direction perpendicular to a Z-axis direction may be formed to be greater than the area of the protruding sensing pad portion 3124.

As described above, as the area of the concave communication pad portion 3216 is formed to be greater than the area of the protruding sensing pad portion 3124, even when the sensing module 31 and/or the communication module 32 is not accurately disposed at a designed location, the sensing module 31 and the communication module 32 may be electrically connected. Accordingly, preciseness needed for assembling a management module 3 can be lowered, and a manufacturing (assembling) time can be reduced.

Referring to FIG. 16, advantages corresponding to the advantages of the present disclosure described with respect to FIGS. 12 to 14 can be seen.

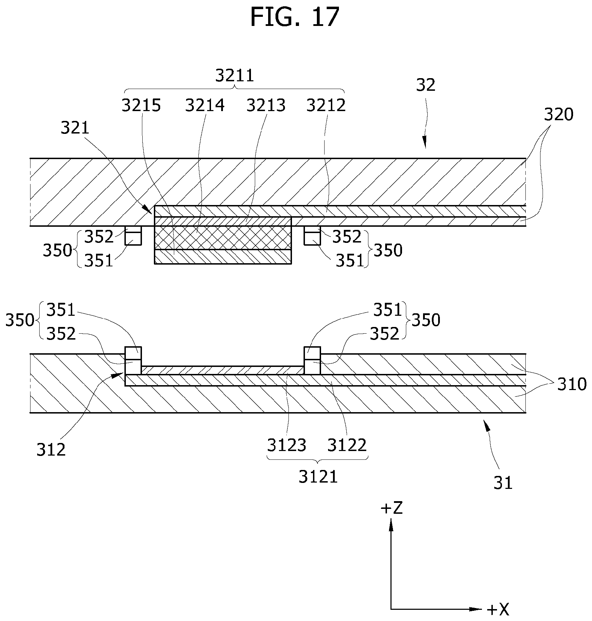

FIG. 17 is a cross-sectional view illustrating a state in which a sensing module is spaced apart from a communication module according to yet another embodiment of the present disclosure.

The embodiment illustrated in FIG. 17 is similar to the embodiment illustrated in FIGS. 10 and 11. The embodiment in which a contact guide part 350 is disposed to be adjacent to a sensing pad portion 312 and a communication pad portion 321 is illustrated in FIG. 17.

Referring to FIG. 17, the contact guide part 350 may be disposed on a sensing module body 310 and a communication module body 320 and may guide contact between the sensing pad portion 312 and the communication pad portion 321.

The contact guide part 350 may include a guide member 351 and an adhesive member 352.

An attraction may act between two guide members 351. According to one or more embodiments, the guide member 351 may be provided as a magnet. A shape of the guide member 351 may be provided as any one of various shapes such as a hexahedral shape and an annular (ring) shape.

A plurality of guide members 351 may be disposed on the sensing module body 310 and/or the communication module body 320, and the attraction may act therebetween. As the attraction acts between the guide members 351, a sensing module 31 and a communication module 32 may come into contact with each other due to the attraction between the plurality of guide members 351 according to desired arrangement of a designer when the sensing module 31 comes into contact with the communication module 32.

In addition, as the attraction between the plurality of guide members 351 acts even after the sensing module 31 and the communication module 32 are in contact with each other, the sensing module 31 and the communication module 32 can be fixed.

The adhesive member 352 may be disposed on the sensing module body 310 and/or the communication module body 320 and may fix the guide member 351. The adhesive member 352 may be provided as any one of various members such as an adhesive and an adhesive tape. According to one or more embodiments, the adhesive member 352 may include an insulating material.

The embodiment, in which the adhesive member 352 disposed on the sensing module 31 is disposed on a sensing line 3122, is illustrated in FIG. 17, but a location at which the adhesive member 352 is disposed is not limited thereto, and the adhesive member 352 may be disposed on (for example, in a +Z-axis direction of) a sensing plate 3123 and/or on the sensing module body 310.

In addition, the embodiment, in which the adhesive member 352 disposed in the communication module 32 is disposed under (for example, in a -Z-axis direction of) the communication module body 320, is illustrated in FIG. 17, but a location at which the adhesive member 352 is disposed may be under (for example, in a -Z-axis direction of) a communication line 3212, under a communication solder 3213, under a communication pad 3214, and/or under a communication plate 3215.

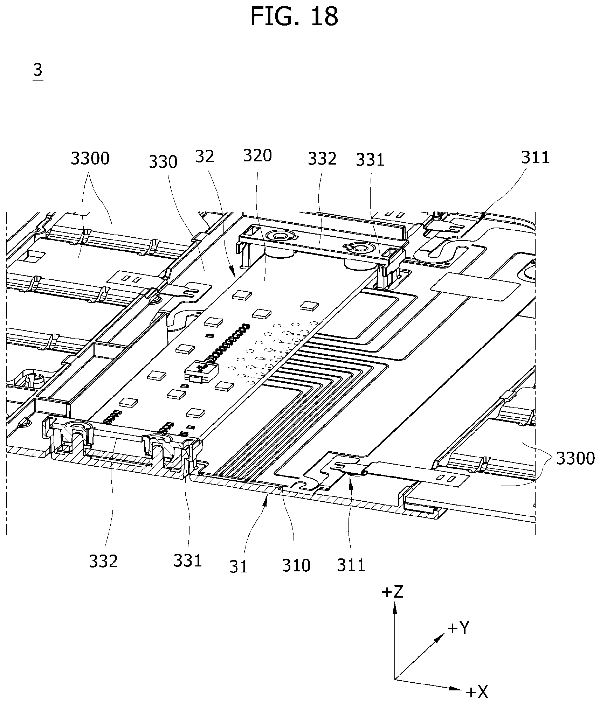

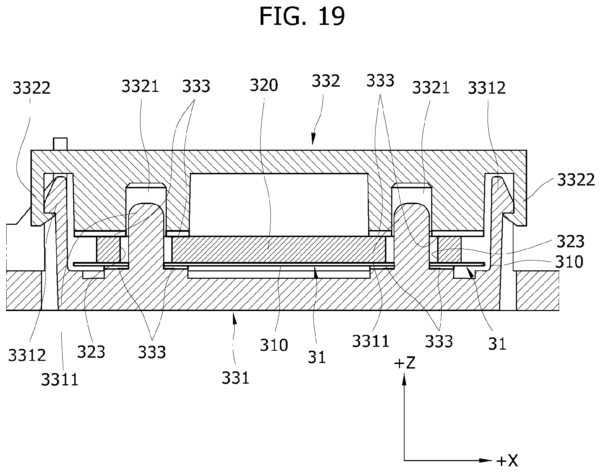

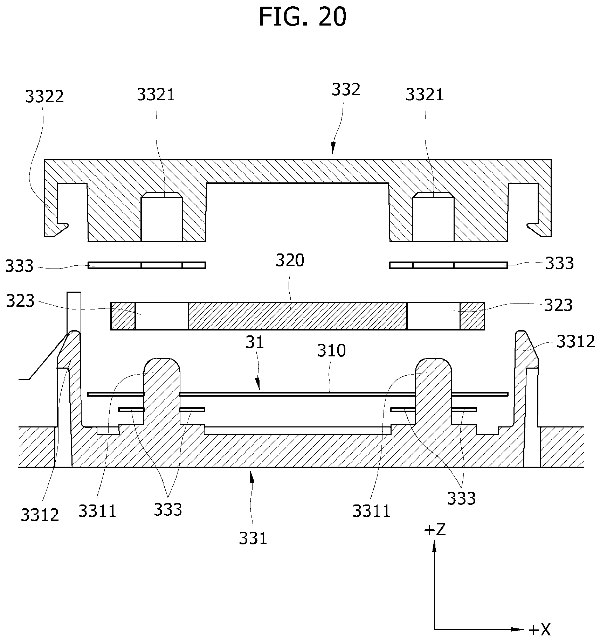

FIG. 18 is a cross-sectional perspective view illustrating the management module according to one or more embodiments of the present disclosure, FIG. 19 is a cross-sectional view illustrating the management module according to one or more embodiments of the present disclosure, and FIG. 20 is an exploded cross-sectional view illustrating the management module according to one or more embodiments of the present disclosure.

A sensing module 31, a sensing module body 310, a sensing part 311, a communication module 32, a communication module body 320, a busbar holder body 330, a busbar 3300, a protruding busbar holder portion 331, and a busbar holder fixing part 332 illustrated in FIGS. 18 to 20 are the same as the sensing module 31, the sensing module body 310, the sensing part 311, the communication module 32, the communication module body 320, the busbar holder body 330, the busbar 3300, the protruding busbar holder portion 331, and the busbar holder fixing part 332 illustrated in FIGS. 1 to 16. Accordingly, description of the same components may be omitted.

Referring to FIGS. 18 to 20, it can be seen that the sensing module body 310 and the communication module body 320 are fixed by the protruding busbar holder portion 331 and the busbar holder fixing part 332.

The protruding busbar holder portion 331 may include a protruding busbar holder pin 3311 and a protruding busbar holder protrusion 3312.

The protruding busbar holder pin 3311 and the protruding busbar holder protrusion 3312 may be disposed to protrude upward (for example, in a +Z-axis direction) from the busbar holder body 330.

The protruding busbar holder pin 3311 may pass through a sensing module body hole 3100 of the sensing module body 310, a communication module body hole 323 of the communication module body 320, and an elastic member 333 and may be inserted into the busbar holder fixing part 332. According to one or more embodiments, the protruding busbar holder pin 3311 may be inserted into a busbar holder fixing groove 3321 formed in a concave shape in the busbar holder fixing part 332.

The protruding busbar holder protrusion 3312 may be coupled to the busbar holder fixing part 332. According to one or more embodiments, the protruding busbar holder protrusion 3312 may be coupled to a busbar holder fixing protrusion 3322 disposed on the busbar holder fixing part 332, and as the protruding busbar holder protrusion 3312 is coupled to the busbar holder fixing protrusion 3322, the busbar holder fixing part 332 may be prevented from being separated from the busbar holder body 330.

The elastic member 333 may be disposed between the sensing module body 310 and the protruding busbar holder portion 331 and/or between the communication module body 320 and the busbar holder fixing part 332. The elastic member 333 may be formed of an elastic material such as rubber.

As the elastic member 333 is disposed between the sensing module body 310 and the protruding busbar holder portion 331 and/or between the communication module body 320 and the busbar holder fixing part 332, damage to the sensing module body 310 and/or the communication module body 320 can be prevented. In addition, as the elastic member 333 presses the sensing module body 310 and the communication module body 320 such that the sensing module body 310 and the communication module body 320 come close to each other, contact between a sensing pad portion 312 of the sensing module body 310 and a communication pad portion 321 of the communication module body 320 can be maintained.

Secondary batteries are widely used for driving or energy storage in not only small apparatuses such as portable electronic devices but also medium-to-large apparatuses such as electric vehicles or energy storage systems (ESSs). In particular, in the case of medium-to-large apparatuses, a plurality of battery cells are electrically connected to form one battery module in order to improve output power and a capacity of a battery.

In such a battery module, a sensing module for measuring a temperature and a voltage of a battery cell to detect a risk of an explosion due to overheating in advance and perform a protection operation is mounted, and a communication module for transmitting information measured by the sensing module is disposed. A connection method for easily detaching and attaching the communication module and the sensing module for maintaining the communication module when the communication between the sensing module and the communication module is performed through a wire is needed.

In a management module and a battery module including the same according to the present disclosure, a communication module and a sensing module can be easily detached and attached.

In addition, in a management module and a battery module including the same according to the present disclosure, damage to a sensing module and a communication module in a process of separating the sensing module and the communication module can be prevented.

In addition, in a management module and a battery module including the same according to the present disclosure, contact between a sensing module and a communication module can be improved.

However, the effects obtainable through the present disclosure are not limited to the above effects, and other technical effects that are not mentioned will be clearly understood by those skilled in the art from the following description of the present disclosure.

While the present disclosure has been described with reference to embodiments shown in the drawings, these embodiments are merely illustrative and it should be understood that various modifications and equivalent other embodiments can be derived by those skilled in the art on the basis of the embodiments.

Therefore, the technical scope of the present disclosure should be defined by the appended claims.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

## Claims

1. A management module, comprising:
a sensing module including a sensing module body, a sensing part extending from the sensing module body, the sensing part configured to detect operation information of battery cells, and a sensing pad portion on the sensing module body, the sensing pad portion being electrically connected to the sensing part; and
a communication module including a communication module body and a communication pad portion on the communication module body, the communication module being in contact with the sensing pad portion and configured to receive the operation information.

2. The management module as claimed in claim 1, wherein:
the sensing pad portion includes a concave sensing pad portion in the sensing module body; and
the communication pad portion includes a protruding communication pad portion protruding from the communication module body, the protruding communication pad portion being seated in the concave sensing pad portion.

3. The management module as claimed in claim 2, wherein a cross-sectional area of the concave sensing pad portion is greater than a cross-sectional area of the protruding communication pad portion.

4. The management module as claimed in claim 2 or 3, wherein a height of the protruding communication pad portion is greater than a depth of the concave sensing pad portion.

5. The management module as claimed in claim 2, 3 or 4, wherein the protruding communication pad portion includes:
a communication line in the communication module body;
a communication solder electrically connected to the communication line;
a communication pad electrically connected to the communication solder; and
a communication plate electrically connected to the communication pad.

6. The management module as claimed in claim 5, wherein the concave sensing pad portion includes:
a sensing line in the sensing module body; and
a sensing plate electrically connected to the sensing line,
wherein the communication plate is in contact with and electrically connected to the sensing plate.

7. The management module as claimed in claim 1, wherein:
the sensing pad portion includes a protruding sensing pad portion protruding from the sensing module body; and
the communication pad portion includes a concave communication pad portion in the communication module body and in which the protruding sensing pad portion is seated.

8. The management module as claimed in any preceding claim, further comprising a busbar holder on which the sensing module is fixedly seated.

9. The management module as claimed in claim 8, wherein the busbar holder includes:
a busbar holder body; and
a protruding busbar holder portion protruding from the busbar holder body.

10. The management module as claimed in claim 9, wherein:
the communication module includes a communication module body hole passing through the communication module body; and
the protruding busbar holder portion is inserted into the communication module body hole.

11. The management module as claimed in claim 9 or 10, wherein the busbar holder includes a busbar holder fixing part coupled to the protruding busbar holder portion, the busbar holder fixing part pressing the communication module toward the sensing module.

12. The management module as claimed in claim 11, wherein the busbar holder includes an elastic member between the communication module and the busbar holder fixing part, the elastic member preventing damage to the communication module.

13. The management module as claimed in claim 11 or 12, wherein:
the protruding busbar holder portion includes a protruding busbar holder pin protruding from the busbar holder body, and
the busbar holder fixing part includes a busbar holder fixing body and a busbar holder fixing groove, the busbar holder fixing groove being concave and in the busbar holder fixing body, the protruding busbar holder pin being inserted into the busbar holder fixing groove.

14. The management module as claimed in claim 11, 12 or 13, wherein:
the protruding busbar holder portion includes a busbar holder protrusion protruding from the busbar holder body; and
the busbar holder fixing part includes a busbar holder fixing protrusion protruding from the busbar holder body, the busbar holder fixing protrusion being coupled to the protruding busbar holder protrusion.

15. A battery module, comprising:
a housing body;
a plurality of battery cells in the housing body; and
a management module in the housing body, the management module collecting operation information of the plurality of battery cells,
wherein the management module is as claimed in any preceding claim.
